# EUROPÄISCHE PATENTSCHRIFT

(11) **EP 2 269 041 B1**
(45) Veröffentlichungstag und Bekanntmachung des Hinweises auf die Patenterteilung: **23.08.2017**
(21) Anmeldenummer: 08846098.5
(22) Anmeldetag: 31.10.2008
(51) Int. Cl.: G01N 21/88, G01N 21/94, G01N 21/03, G01N 21/01, G01N 21/95

(54) **INSPEKTIONSVORRICHTUNG**
INSPECTION DEVICE
DISPOSITIF D'INSPECTION

(30) Priorität: 01.11.2007 DE 102007052530
(43) Veröffentlichungstag der Anmeldung: 05.01.2011
(73) Patentinhaber: ZS-Handling GmbH, 93055 Regensburg (DE)
(72) Erfinder: SCHILP, Michael, 93055 Regensburg (DE); ZIMMERMANN, Josef, 93055 Regensburg (DE); ZITZMANN, Adolf, 92552 Teunz (DE)
(74) Vertreter: Staudte, Ralph
(86) Internationale Anmeldenummer: PCT/DE2008/001790
(87) Internationale Veröffentlichungsnummer: WO 2009/056127

(56) Entgegenhaltungen:
- WO-A1-2004/076320
- WO-A2-2004/059695
- US-A1- 2004 174 518
- US-B2- 6 810 297

## Beschreibung

Die Erfindung betrifft eine Vorrichtung zur Inspektion von berührungsempfindlichen flächigen Materialien oder Werkstücke, wie z. B. Wafern für die Halbleiterindustrie, Solarzellen, Gläser, FPD-Substrate oder biologisch aktive Substrate für Bio-Sensoren, aber auch von Materialien mit berührungsempfindlichen gekrümmten Oberflächen. Nachfolgend wird jede Art von Material oder Werkstücke als Material bezeichnet. Die Oberflächen von Materialien werden in diversen Arbeitsgängen bearbeitet, wobei unter Bearbeiten z. B. Arbeitsschritte wie Bedampfen oder Strukturieren zu verstehen sind. Nach der Bearbeitung wird das Arbeitsergebnis inspiziert. Dazu kann z. B. eine Kamera mit einem Bilderkennungs- und Auswerteprogramm verwendet werden.

Technologien, bei denen eine Bearbeitung sowohl der Oberseite als auch der Unterseite der Materialien vorgesehen ist, erfordern auch eine beidseitige Inspektion. Die Inspektion der Oberseite ist leicht durchführbar, da das Material auf einem Prüftisch oder auf einem Förderband aufliegt und somit eine freie Sicht auf die Oberfläche gegeben ist. Die gleichzeitige Inspektion der Materialunterseite ist schwierig, da das Material von der Unterseite wenigstens zum Teil von der Auflagefläche abgedeckt wird, so dass z. B. eine Kamera nicht die gesamte Unterseite scannen kann.

Wenn z. B. eine Solarzelle transportiert wird, deren Unterseite sehr empfindlich gegen mechanische Berührung ist, so liegt diese Solarzelle auf mehreren schmalen Förderbändern auf. Mit einer Kamera können von unten jedoch nur die Flächenabschnitte der Solarzelle inspiziert werden, die von den Förderbändern nicht abgedeckt werden. Wenn es jedoch erforderlich ist, die komplette Unterseite zu inspizieren, muss die Solarzelle vom Transportband genommen und gewendet werden, was jedoch bei kontinuierlich ablaufenden Prozessen aufwendig und störanfällig ist.

Zur Lösung dieser Probleme ist es aus dem Stand der Technik bekannt, die Transportbahn in mehrere, jeweils durch einen Spalt getrennte Segmente zu unterteilen, sodass eine Übergabe des Materials von einem Segment zum anderen erfolgt. An diesem Übergabespalt wird das Material nicht abgestützt und kann daher in seiner Gesamtbreite gescannt werden. Es gibt jedoch Probleme, wenn der Übergabespalt sehr schmal gehalten werden muss, weil die Materialien eine zu geringe Eigensteifigkeit haben. Mitunter ist dann ein ungehindertes Scannen nicht mehr möglich.

In der Druckschrift WO 2004/076320 A1 ist eine Vorrichtung zum berührungslosen Transportieren und Positionieren von Bauteilen an einer Transportbahn beschrieben. Die Vorrichtung umfasst Mittel zum Erzeugen eines Schwebezustandes eines Bauteils an der Transportbahn, Mittel zum Kippen der Transportbahn in die Transportrichtung, so dass das Bauteil unter Wirkung der Gravitationskraft berührungslos abwärts einem Zielpunkt entgegen gleitet, Mittel zur berührungslosen Erfassung der Lage des Bauteils und eine Regelvorrichtung, wobei die Lageerfassung des Bauteils wenigstens innerhalb eines vorbestimmten Abschnitts des anzufahrenden Zielpunktes erfolgt und mittels eines Rechen- und Regelalgorithmus ein Zeitpunkt bestimmt wird, zu dem die Transportbahn um einen vorbestimmten Kippwinkel in einer vorbestimmten Winkelgeschwindigkeit verschwenkt und wieder zurückgeschwenkt wird, so dass das Bauteil abgefangen wird, wobei die Transportbahn nach dem Verschwenken waagerecht ausgerichtet ist und das Bauteil im Zielpunkt liegt.

In der Druckschrift US 2004/174518 A1 ist eine Inspektionsvorrichtung beschrieben, die eine Inspektion von beispielsweise Halbleiterwafern von zwei Seiten ermöglicht. Bei einer Variante dieser Inspektionsvorrichtung sind oberhalb und unterhalb eines zu inspizierenden Wafers jeweils eine Lichtquelle und eine Kamera angeordnet, mit deren Hilfe die beiden Seiten des Wafers inspiziert werden. Der Wafer kann mittels Ultraschallwellen in der Schwebe gehalten und transportiert werden.

In der Druckschrift WO 2004/059695 ist eine Vorrichtung zum thermischen Behandeln von scheibenförmigen Substraten wie beispielsweise Halbleiterwafern beschrieben. Ein Substrat wird mittels Ultraschallevitation in einer Schnellheizanlage gehalten und über eine vom Substrat beabstandete Strahlungsquelle erwärmt. Zwischen der Strahlungsquelle und dem Substrat ist eine für die Strahlung der Strahlungsquelle durchlässige Wand angeordnet.

Es ist die Aufgabe der Erfindung, eine Möglichkeit zu schaffen, um berührungsempfindliche Materialien, die auf einer Transportstrecke transportiert werden, an ihrer Unterseite optisch vollständig inspizieren zu können, d. h., ohne dass die Inspektion an der Auflagefläche der Materialien durch Abdeckung behindert wird.

Diese Aufgabe wird mit einer Inspektionsvorrichtung nach Anspruch 1 und mit einer Transport- und Inspektionsvorrichtung nach Anspruch 5 gelöst.

Die Erfindung nach Anspruch 1 betrifft eine Inspektionsvorrichtung, die einen Trägerkörper zum Tragen eines zu inspizierenden Materials aufweist. An diesem Trägerköper ist ein Schwingungserzeuger angekoppelt, der den Trägerköper in Schwingungen versetzt, wobei die Schwingungsfrequenz und - amplitude so gewählt sind, um das zu inspizierende Material auf der Oberseite des Trägerkörpers durch Ultraschalllevitation in der Schwebe zu halten. Der Trägerkörper hat eine Oberflächenform, die der geometrischen Form der Materialunterseite angepasst ist.

Der Träger ist erfindungsgemäß lichtdurchlässig, sodass die Unterseite des Materials mittels eines optischen Sensors, wie z. B. einer Kamera, eines Interferometers, eines Speckle-Messgerätes oder einer Zeilenkamera inspiziert, d. h. optisch abgetastet werden kann.

Somit wird es möglich, berührungsempfindliche Materialien, wie z. B. Wafer oder Solarzellen während einer Inspektion der Unterseite berührungslos zu halten und die Unterseite vollständig zu inspizieren.

In Abhängigkeit von dem für die Inspektion verwendetem Licht kann es gemäß der Ansprüche 2 bis 4 zweckmäßig sein, den Trägerkörper aus Glas, aus lichtdurchlässiger Keramik, wie z. B. Saphir oder aus einem schwingungsfähigen lichtdurchlässigen Kunststoff auszubilden.

Dem Fachmann ist klar, dass die optischen Eigenschaften des Trägerkörpers sowohl von dem Material abhängig sind, aus dem der Trägerkörper besteht, als auch von der geometrischen Form des Trägerkörpers und von der eingesetzten Lichtwellenlänge.

Z. B. zum Transport von Wafern ist die Oberfläche des Trägerkörpers eben und der Trägerkörper ist als planparallele Platte ausgebildet. Der Fachmann für die Dimensionierung optischer Systeme wird demzufolge bei der Auslegung des optischen Sensors die optischen Eigenschaften der planparallelen Platte hinsichtlich Lichtbrechung berücksichtigen.

Wenn dagegen z. B. Stangenmaterial mit einem kreisförmigen Querschnitt berührungslos zu halten und zu inspizieren ist, liegt das Stangenmaterial in einer halbkreisförmigen Kehle des Trägerkörpers, wobei der Radius der Kehle dem des Stangenmaterials entspricht. Die optischen Eigenschaften des Trägerkörpers sind andere als bei einer planparallelen Platte, sodass der Fachmann die Brechungs- und Reflexionseigenschaften von gekrümmten Flächen zu berücksichtigen hat, was sowohl für die Ausgestaltung des optischen Sensors als auch für die Ausgestaltung der Beleuchtungsvorrichtung gilt.

Somit ist der Trägerkörper als optisches Bauelement zu betrachten und kann mit allen bekannten Technologien zur Herstellung und Beschichtung von optischen Bauelementen gefertigt werden.

Nach Anspruch 5 wird eine Transport- und Inspektionsvorrichtung bereitgestellt, auf der Materialien entlang eines Transportweges transportiert werden. An einer Stelle des Transportweges ist eine Inspektionsvorrichtung nach einem der Ansprüche 1 bis 4 angeordnet.

Weil die Trägerplatte von der Form und der Größe des zu tragenden Materials abhängig ist und die zu inspizierende Fläche die gesamte Materialfläche oder auch nur ein Abschnitt davon sein kann, ist es nicht möglich, konkrete geometrische Angaben über die Konstruktion und die Form der Trägerplatte zu machen. Dem Fachmann ist bei Kenntnis der offenbarten technischen Lehre klar, dass für die Inspektion nur der Flächenabschnitt der Trägerplatte genutzt werden kann, in welchem die Ausbreitung der Lichtstrahlung nicht abgeschattet oder gestört wird.

Es ist dem Fachmann klar, wie die von einem optischen Sensor bereitgestellten Signale auszuwerten sind. Da die Signalverarbeitung- und Auswertung nicht Gegenstand der Erfindung sind, sondern aus dem Stand der Technik bekannt sind, ist für den Fachmann eine nähere Erläuterung nicht erforderlich.

Die Erfindung wird nachfolgend anhand eines Ausführungsbeispiels und beigefügter schematischer Zeichnungen näher erläutert:
- Fig. 1: zeigt eine perspektivische und schematische Ansicht einer Träger-Platte mit einem darauf aufliegenden flächigen Material.
- Fig. 2: zeigt die Trägerplatte nach Fig. 1 in der Seitenansicht mit einer Kamera.

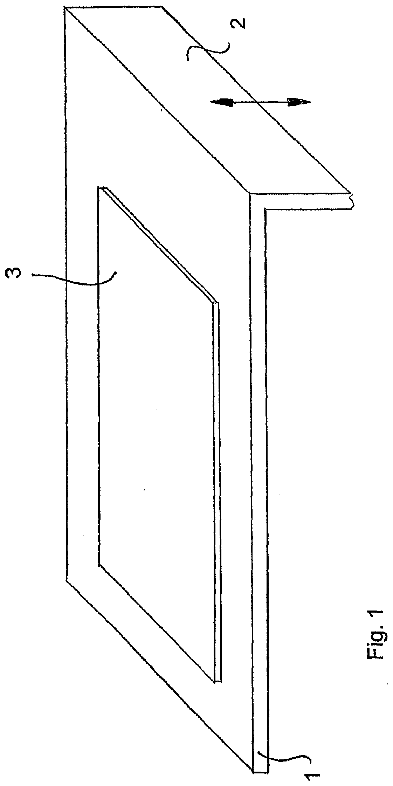

Die Fig. 1 zeigt in einer perspektivischen und schematischen Ansicht eine Trägerplatte 1, die seitlich abgewinkelt ist. Der Schenkel 2 ist mit einem Schwingungserzeuger gekoppelt (nicht gezeigt). Der Doppelpfeil symbolisiert die Schwingungserzeugung. Das flächige Material 3 ist eine Siliziumscheibe, die 0, 1 mm über der Trägerplatte 1 schwebt.

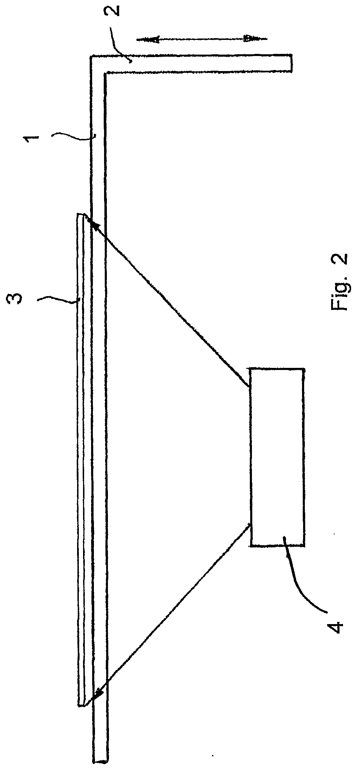

Die Fig. 2 zeigt in einer Seitenansicht die Konstruktion nach Fig. 1. Unterhalb der Trägerplatte 1 ist eine Kamera 4 angeordnet, mit der die nicht aufliegende Unterseite der Siliziumscheibe inspiziert wird. Die Trägerplatte ist aus optischem Glas und wird seitlich von unten beleuchtet.

## Patentansprüche

1. Inspektionsvorrichtung, die aufweist:
- einen Trägerkörper (1) zum Tragen eines Materials (3) auf der Oberseite des Trägerkörpers (1),
- wenigstens ein Schwingungserzeuger, der mit dem Trägerkörper (1) verbunden ist, wobei die Schwingungsfrequenz und - amplitude des Schwingungserzeugers so ausgewählt sind, um das Material (3) auf dem Trägerkörper (1) in der Schwebe zu halten **dadurch gekennzeichnet, dass** die Inspektionsvorrichtung ferner aufweist
- wenigstens einen optischen Sensor,
wobei
- der Trägerkörper (1) aus einem lichtdurchlässigen Material besteht und
- der optische Sensor unterhalb des Trägerkörpers (1) angeordnet ist.

2. Inspektionsvorrichtung nach Anspruch 1, **dadurch gekennzeichnet, dass** der Trägerkörper (1) aus Glas besteht.

3. Inspektionsvorrichtung nach Anspruch 1, **dadurch gekennzeichnet, dass** der Trägerkörper (1) aus lichtdurchlässiger Keramik besteht.

4. Inspektionsvorrichtung nach Anspruch 1, **dadurch gekennzeichnet, dass** der Trägerkörper (1) aus schwingungsfähigem lichtdurchlässigen Kunststoff besteht.

5. Transport- und Inspektionsvorrichtung für zu befördernde und zu inspizierende Materialien, die mittels Transportmittel entlang einer Transportstrecke bewegt werden, **dadurch gekennzeichnet, dass** an oder innerhalb der Transportstrecke eine Inspektionsvorrichtung nach einem der Ansprüche 1 bis 4 angeordnet ist.

## Claims

1. An inspection device, comprising:
- a support element (1) for supporting a material (3) on the top side of said support element (1),
- at least one oscillator connected to the support element (1), wherein the oscillation frequency and amplitude generated by the oscillator are selected to keep the material (3) hovering over the support element (1), **characterised in that** the inspection device further comprises
- at least one optical sensor,
wherein
- the support element (1) is made of a transparent material and
- the optical sensor is arranged underneath the support element (1).

2. The inspection device according to claim 1, **characterised in that** the support element (1) is made of glass.

3. The inspection device according to claim 1, **characterised in that** the support element (1) is made of a transparent ceramic material.

4. The inspection device according to claim 1, **characterised in that** the support element (1) is made of an oscillatory transparent plastic material.

5. A transport and inspection device for materials which are to be transported and inspected, and which are moved by transport means along a transport path, **characterised in that** an inspection device according to any one of claims 1 to 4 is arranged at or within the transport path.

## Revendications

1. Dispositif d'inspection comprenant:
- un corps de support (1) destiné au support d'un matériau (3) sur le côté supérieur du corps de support (1),
- au moins un générateur de vibrations qui est relié au corps de support (1), dans lequel la fréquence et l'amplitude de vibration du générateur de vibrations sont sélectionnées de sorte à maintenir le matériau (3) en suspension au-dessus du corps de support (1), **caractérisé en ce que** le dispositif d'inspection comprend en outre
- au moins un capteur optique,
dans lequel
- le corps de support (1) est formé d'un matériau perméable à la lumière et
- le capteur optique est disposé au-dessous du corps de support (1).

2. Le dispositif d'inspection selon la revendication 1, **caractérisé en ce que** le corps de support (1) est en verre.

3. Le dispositif d'inspection selon la revendication 1, **caractérisé en ce que** le corps de support (1) est en céramique perméable à la lumière.

4. Le dispositif d'inspection selon la revendication 1, **caractérisé en ce que** le corps de support (1) est en matière plastique perméable à la lumière et pouvant vibrer.

5. Dispositif de transport et d'inspection pour des matériaux à transporter et à inspecter qui se déplacent au moyen d'un mode de transport le long d'une voie de transport, **caractérisé en ce qu'**un dispositif d'inspection selon l'une quelconque des revendications de 1 à 4 est disposé sur la voie de transport ou à l'intérieur de la voie de transport.
